(19) **Europäisches Patentamt / European Patent Office / Office européen des brevets**

(11) **EP 4 723 164 A1**

(12) **EUROPEAN PATENT APPLICATION**
published in accordance with Art. 153(4) EPC

(43) Date of publication:
**08.04.2026 Bulletin 2026/15**

(21) Application number: **24815622.6**

(22) Date of filing: **31.05.2024**

(51) International Patent Classification (IPC):
*H01L 21/52* (2006.01)   *B22F 1/00* (2022.01)
*B22F 7/04* (2006.01)   *B22F 9/00* (2006.01)
*H05K 1/14* (2006.01)   *H05K 3/32* (2026.01)
*H05K 3/36* (2006.01)

(52) Cooperative Patent Classification (CPC):
**B22F 1/00; B22F 7/04; B22F 9/00; H05K 1/14; H05K 3/32; H05K 3/36; H10W 72/071**

(86) International application number:
**PCT/JP2024/020076**

(87) International publication number:
**WO 2024/248142 (05.12.2024 Gazette 2024/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **02.06.2023 JP 2023091515**

(71) Applicant: **Mitsui Kinzoku Company, Limited Tokyo 141-8584 (JP)**

(72) Inventors:
• **SHIRAKAWA, Yuki**
  **Ageo-shi, Saitama 362-0021 (JP)**
• **HATTORI, Takashi**
  **Ageo-shi, Saitama 362-0021 (JP)**
• **YAMAUCHI, Shinichi**
  **Ageo-shi, Saitama 362-0021 (JP)**
• **ANAI, Kei**
  **Ageo-shi, Saitama 362-0021 (JP)**

(74) Representative: **Novagraaf Technologies**
  **2 rue Sarah Bernhardt**
  **CS90017**
  **92665 Asnières-sur-Seine Cedex (FR)**

(54) **METHOD FOR MANUFACTURING JOINT STRUCTURE, METHOD FOR MANUFACTURING LAMINATE, AND JOINT METHOD**

(57) A paste containing copper particles and an organic solvent is applied to a first member 11 to form a coating layer 13a; the organic solvent is partially removed from the coating layer 13a; pressing a second member 12 into the coating layer 13a to partially embed the second member 12 in the coating layer 13a to form a stack having the first member 11, the coating layer 13a, and the second member 12 in that order, and heating the stack 14. A press-in ratio P, defined as $100 - (Y/X \times 100)$, is 1.0 to 50, wherein X is an average thickness of the coating layer 13a in a state after the drying step and before pressing the second member 12 into the coating layer 13a; and Y represents an average distance from the upper surface 11b of the first member 11 to the lower surface 12b of the second member 12 in the state after forming the stack 14.

Fig. 1

EP 4 723 164 A1

## Description

### Technical Field

This invention relates to a method for producing a joint structure in which two members are joined together. It also relates to a method for producing a stack that can be used to obtain a joint structure and a method for joining two members.

### Background Art

In recent years, the use of semiconductor devices called power devices as power conversion and control equipment, such as inverters, has been increasing. Unlike integrated circuits, such as memories and microprocessors, power devices are designed to control a high current, which causes them to generate a very large amount of heat during operation. Therefore, the solder used to mount a power device must be heat-resistant. Lead-free solder currently in widespread use has the disadvantage of lower heat resistance than lead-containing solder.

Various techniques replacing the use of solder have been proposed, in which a paste containing fine metallic particles and limited amounts of harmful chemicals is applied between members to be joined using various coating methods, followed by firing. For example, patent literature 1 shown below discloses applying a conductive paste containing fine metallic particles to an electrode pattern, placing a semiconductor device on the paste, and heating the paste while applying pressure to the paste by pressing the semiconductor device to form a sintered layer of the fine metallic particles.

### Citation List

Patent Literature

Patent literature 1: JP 2016-127219A

### Summary of Invention

According to the technique of patent literature 1, when a semiconductor device placed on the conductive paste coating layer is transported or vibrated by an external force, the semiconductor device can shift out of position. This can lead to joint failure between the semiconductor device and the electrode pattern. Accordingly, an object of the invention is to provide a method for producing a joint structure in which members are successfully joined together without involving positional shifting or detachment.

The invention provides a method for producing a joint structure having a first member, a second member and a joint layer joining the first member and the second member,

the method comprising

a step of applying a paste comprising copper particles and an organic solvent to the first member to form a coating layer,
a drying step of drying the coating layer to partially remove the organic solvent contained in the coating layer,
a pressing step of pressing the second member into the coating layer until a portion of the second member is embedded in the coating layer to form a stack comprising the first member, the coating layer, and the second member in that order, and
a heating step of heating the stack, and

the pressing step being performed to achieve a press-in ratio P of from 1.0 to 50, the press-in ratio P being defined as $100 - (Y/X \times 100)$,
wherein X represents an average thickness ($\mu$m) of the coating layer in a state after the drying step and before pressing the second member into the coating layer; and
Y represents an average distance ($\mu$m) from an upper surface of the first member to a lower surface of the second member in a state after forming the stack.

The invention also provides a method for producing a stack for joining a first member and a second member,

the method comprising

a step of applying a paste comprising copper particles and an organic solvent to the first member to form a coating layer,

a drying step of drying the coating layer to partially remove the organic solvent contained in the coating layer, and

a pressing step of pressing the second member into the coating layer until a portion of the second member is embedded in the coating layer to form a stack comprising the first member, the coating layer, and the second member in that order, and

the pressing step being performed to achieve a press-in ratio P of 1.0 to 50, the press-in ratio P being defined as 100 - (Y/X × 100),

wherein X represents an average thickness (μm) of the coating layer in a state after the drying step and before pressing the second member into the coating layer; and

Y represents an average distance (μm) from an upper surface of the first member to a lower surface of the second member in a state after forming the stack.

The invention also provides a method for joining a first member and a second member,

the method comprising

a step of applying a paste comprising copper particles and an organic solvent to the first member to form a coating layer,

a drying step of drying the coating layer to partially remove the organic solvent contained in the coating layer,

a pressing step of pressing the second member into the coating layer until a portion of the second member is embedded in the coating layer to form a stack comprising the first member, the coating layer, and the second member in that order, and

a heating step of heating the stack, and

the pressing step being performed to achieve a press-in ratio P of from 1.0 to 50, the press-in ratio P being defined as 100 - (Y/X × 100),

wherein X represents an average thickness (μm) of the coating layer in a state after the drying step and before pressing the second member into the coating layer; and

Y represents the average distance (μm) from an upper surface of the first member to a lower surface of the second member in a state after forming the stack.

**Brief Description of Drawings**

[Fig. 1] Fig. 1 is a step flow diagram illustrating an embodiment of the method for producing a joint structure according to the invention (a step diagram showing the steps up to stack formation).

[Fig. 2] Fig. 2 is a schematic enlarged view of an essential part of a stack in which a second member is pressed and embedded in a dried coating layer.

[Fig. 3] Fig. 3(a), Fig. 3(b), and Fig. 3(c) are schematic diagrams showing the method for determining X and Y values for calculating a press-in ratio P defined as 100 - (Y/X × 100).

**Description of Embodiments**

The invention will be described on the basis of its preferred embodiments. The invention relates to a method for producing a joint structure having two members, i.e., a first member and a second member, joined via a joint layer. The method roughly includes the following steps:

1. Step of applying a paste containing copper particles and an organic solvent to a first member to form a coating layer
2. Drying step of drying the coating layer to partially remove the organic solvent
3. Pressing step of pressing a second member into the coating layer until a portion of the second member is embedded in the coating layer to form a stack having the first member, coating layer, and second member in that order
4. Heating step of heating the stack

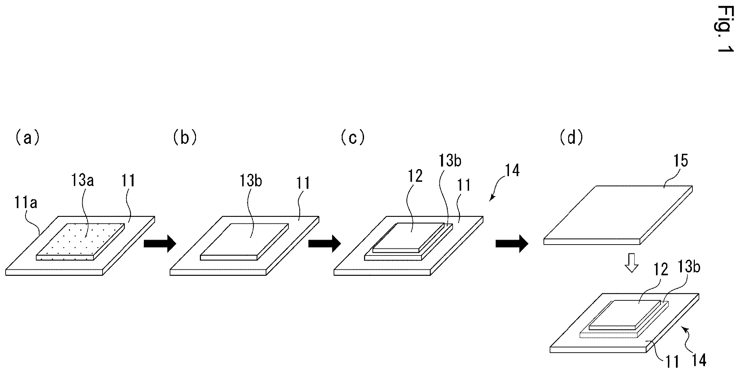

The steps 1 to 4 will be elaborated upon with reference to Fig. 1.

As illustrated in Fig. 1(a), a first member 11 is provided. A paste is applied to one side of the first member 11 to form a wet coating layer 13a. The paste contains copper particles and an organic solvent. The paste coating method for the formation of the wet coating layer 13a is not limited and includes screen printing, gravure printing, dispenser printing, reverse coating, and doctor blading.

To ensure sufficient joint strength, the wet coating layer 13a preferably has an average thickness of at least 18 $\mu$m, more preferably 20 $\mu$m or more, and even more preferably 25 $\mu$m or more. To form a coating layer with a smooth surface and prevent the coating layer from cracking after drying, the average thickness of the wet coating layer 13a is preferably 1000 $\mu$m or less, more preferably 800 $\mu$m or less, and even more preferably 500 $\mu$m or less.

The average thickness of the wet coating layer 13a can be measured, for example, with a non-contact surface profiler using white-light interferometry. As the non-contact surface profiler, for example, ZeGage Pro from Ametek Inc. may be used. In this case, the software is ZYGO Mx, version 8.0.0, with the zoom lens set to 1.0×, and the objective lens set to 1.4×. The basic settings are configured within the "Measurement Tab". Then, in the "Option Tab", "Extended" is selected for the scan length, a value at least 100 $\mu$m greater than the thickness of the coating layer 13a to be measured is entered, and the scan start position is set to "Bottom". The measurement field of view is adjusted such that a part of the first member 11 serving as the reference surface for the thickness is included in the image recognition of the coating layer 13a to be measured. Specifically, the measurement field of view is set to extend by at least 1 mm beyond the periphery of the wet coating layer 13a. By setting the measurement field of view to partially include the first member 11 serving as the reference surface, Rectangle R (hereinafter described) can be positioned within an appropriate range.

Once the setting is complete, the measurement is performed. Upon completion, in the software under the "Analysis Tab," the "Investigation Tools" menu is opened, and by selecting "Add Shapes (One Reference and One Test Default Rectangles)," Rectangle R for defining the reference surface and Rectangle T for measuring the height from the reference surface are displayed.

Rectangle R is positioned at a location where the first member 11 is present and the coating layer 13a is not included, with each side being at least 500 $\mu$m in length. If any portion other than the first member 11 is included within Rectangle R, the reference cannot be properly defined. Since Rectangle R serves as the reference for calculating the thickness of the coating layer to be measured, it must not include any portion other than the first member 11. By positioning Rectangle R with each side having a length of at least 500 $\mu$m, an average value that takes into account the surface roughness of the first member 11 is used as the reference, thereby enabling more accurate calculation of the thickness of the coating layer 13a.

Then, Rectangle T is positioned 500 $\mu$m inside from each of the vertical and horizontal edges of the wet coating layer 13a to be measured. Thereafter, by clicking "Apply" in the item displayed as "Level/Step," a numerical value appears inside Rectangle T. This value is taken as the average thickness of the wet coating layer 13a.

The paste is applied to one side of the first member 11 within an area inside the periphery of that side. Fig. 1(a) shows the state where a single coating layer (wet coating layer 13a) is formed by applying the paste to an area inside the periphery 11a of one surface of the first member 11. To form a reliable joint between the first member 11 and a second member 12, the paste coating area is preferably such that the resulting wet coating layer 13a extends beyond the periphery of the hereinafter described second member 12 to be joined.

The wet coating layer 13a is then dried to partially remove the organic solvent present in the wet coating layer 13a to form a dried coating layer 13b as illustrated in Fig. 1(b). Partial removal of the organic solvent from the wet coating layer 13a leads to the formation of the dried coating layer 13b with enhanced shape retention. From this perspective, in the drying step depicted in Fig. 1(b), the wet coating layer 13a is dried in such a manner that the mass of the wet coating layer 13a is reduced by preferably 3.0 mass% or more, more preferably 3.2 mass% or more, even more preferably 5.0 mas% or more, and still more preferably 7.0 mass% or more.

If the organic solvent is excessively removed from the wet coating layer 13a, the dried coating layer 13b might become hard. This can result in unsuccessful pressing of the second member into the dried coating layer 13b. From this viewpoint, in the drying step, the wet coating layer 13a is dried in such a manner that the mass of the wet coating layer 13a is reduced by 30.0 mass% or less and more preferably 28.0 mass% or less. The method for measuring reduction in mass, mass loss ratio, of the wet coating layer 13a will be described in Examples given later.

To ensure the successful pressing of the second member 12 into the dried coating layer 13b, the level of organic solvent removal in the drying step is preferably such that the dried coating layer 13b retains an average thickness of at least 15 $\mu$m, more preferably 18 $\mu$m or greater, and even more preferably 20 $\mu$m or greater. On the other hand, to form a coating layer with a smooth surface and prevent cracking of the coating layer after drying, the organic solvent is preferably removed in the drying step until the average thickness of the dried coating layer 13b is reduced to 800 $\mu$m or smaller, more preferably 500 $\mu$m or smaller, and even more preferably 400 $\mu$m or smaller. The method for measuring the average thickness X of the dried coating layer 13b will be described later.

In order to control the vaporization of the organic solvent during the drying step shown in Fig. 1(b) so as to result in appropriate hardness of the dried coating layer 13b, it is preferred to adjust the heating temperature for drying the wet coating layer 13a within an appropriate range. From this perspective, when the drying step is carried out under atmospheric pressure, the heating temperature is preferably set within a range of from 20°C to the boiling point (M°C) of the organic solvent present in the wet coating layer 13a, more preferably from 25°C to (M - 10)°C, and even more preferably from 30°C to (M - 20)°C. In the case where two or more organic solvents are present in the wet coating layer 13a, the M is defined as the highest boiling point of the organic solvents.

In connection with the heating temperature, the heating time for the wet coating layer 13a should be decided so as to result in such hardness of the dried coating layer 13b that allows the second member 12 to be successfully pressed into the dried coating layer 13b. When the drying step is carried out under atmospheric pressure, the heating is preferably performed for approximately 1 to 120 minutes.

The heat drying for the wet coating layer 13a to provide the dried coating layer 13b may be carried out in an inert gas atmosphere or in the atmosphere, or under reduced pressure. The heating method is not limited and can be selected from, for example, hot air blowing, infrared ray irradiation, and oven heating.

After the dried coating layer 13b is formed, the second member 12 is placed on the dried coating layer 13b as illustrated in Fig. 1(c). The second member 12 is preferably positioned such that the dried coating layer 13b extends outward from the periphery of the second member 12.

In this embodiment, it is not necessary to apply a fixing agent between the second member 12 and the dried coating layer 13b before placing the second member 12 on the coating layer 13b. As will be described later, in the embodiment, since the second member 12 is pressed into the dried coating layer 13b until it is partially embedded in the dried coating layer 13b, there is no need to fix the second member 12 to the dried coating layer 13b by applying a fixing agent. Thus, the joining method of the embodiment enables omitting the step of applying a fixing agent, thereby streamlining the production steps and reducing production time. The absence of a need for a fixing agent does not preclude a possible use of a fixing agent. Examples of usable fixing agents include monohydric alcohols, polyhydric alcohols, polyhydric alcohol alkyl ethers, polyhydric alcohol aryl ethers, esters, heterocyclic compounds, amides, amines, saturated hydrocarbons, cyclic terpen alcohols and derivatives thereof, ketones, and carboxylic acids.

As previously mentioned, since the organic solvent partially remains in the dried coating layer 13b, the dried coating layer 13b exhibits deformability as well as shape retention. Therefore, when a pressing force is imposed to the second member 12 placed on the dried coating layer 13b, the dried coating layer 13b deforms, and a portion of the second member 12 is embedded in the dried coating layer 13b. Consequently, a stack 14 composed of the first member 11, dried coating layer 13b, and second member 12 in that order is formed. A pressing jig, e.g., a plate 15 shown in Fig. 1(d), may be used to press in the second member 12. Alternatively, an unshown jig for placing the second member 12 may be used for not only placement but pressing in, or a jig for placement can be used to pick up an appropriate weight and bring the weight into contact with the second member 12 to press it into the dried coating layer 13b.

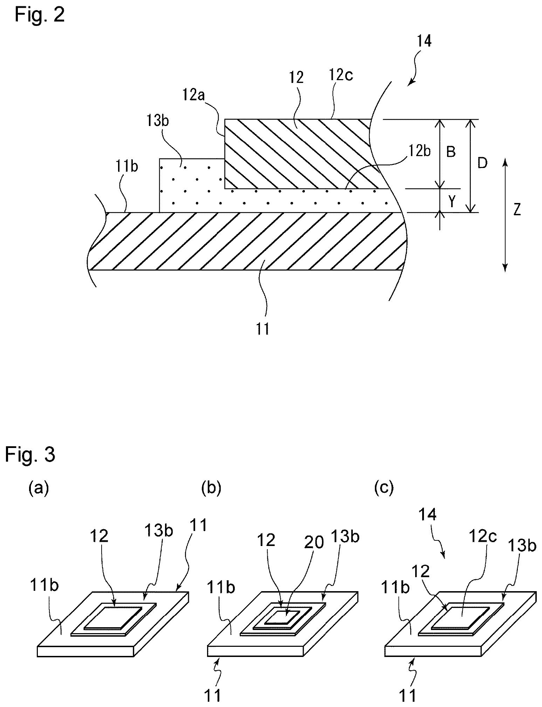

Fig. 2 shows an enlarged view of an essential part of the stack in which the second member 12 is partially embedded in the dried coating layer 13b. As illustrated, a lower portion in the thickness direction Z of the second member 12 pressed into the dried coating layer 13b is embedded in the dried coating layer 13b. As a result, the lateral surface 12a of the embedded lower portion is surrounded by the dried coating layer 13b, whereby the second member 12 is fixed in the dried coating layer 13b. The fixing of the second member 12 by the dried coating layer 13b is accomplished through a tight fit between the dried coating layer 13b and the lateral surface 12a of the lower portion of the second member 12 and also through the tackiness of the dried coating layer 13b.

In order to ensure the fixation of the second member 12 by the dried coating layer 13b and the subsequent joining of the first and second members 11 and 12, the inventors found it necessary that the conditions for pressing the second member 12 satisfy the predetermined relationship described below. Specifically, it is advantageous to perform the pressing of the second member 12 to achieve a press-in ratio P defined by equation (1) below of 1.0 or higher, preferably 1.5 or higher, more preferably 2.0 or higher, and even more preferably 2.5 or higher.

On the other hand, in order to obtain a sufficiently enhanced joint strength between the first and second members 11 and 12 in the joint structure that is obtained by sintering the stack 14, it is desirable that the dried coating layer 13b located between the first and second members 11 and 12 in the stack 14 not be thinner than necessary. From this viewpoint, the press-in ratio P is 50 or lower, preferably 30 or lower, and more preferably 25 or lower.

$$P = (Y/X \times 100) \qquad\qquad (1)$$

In the equation (1), X represents an average thickness ($\mu$m) of the coating layer 13b in a state after the drying step of the wet coating layer 13a and before pressing the second member 12 into the dried coating layer 13b; and Y represents an average distance ($\mu$m) from the upper surface 11b of the first member 11 to the lower surface 12b of the second member 12 after forming the stack 14.

X and Y are measured as follows.

Following the drying step of the wet coating layer 13a, the second member 12 is placed on the center of the dried coating layer 13b using a chip mounter with an applied low pressure of 0.004 MPa, as illustrated in Fig. 3(a). The time interval between the contact of the second member 12 with the dried coating layer 13b and the pressure reaching 0.004 MPa is set to, for example, within one second, and the time for maintaining the pressure of 0.004 MPa is set to 0.4 seconds. The average total thickness A of the dried coating layer 13b and the second member 12, measured from the upper surface 11b of the first member, is calculated using the same method as for the wet coating layer 13a. Subtracting the average thickness B (see Fig. 2) of the second member 12 from the average total thickness A gives the average thickness X ($\mu$m) of the dried coating layer 13b. The average thickness B of the second member 12 has been measured in advance.

The average thickness B of the second member 12 can be measured using the same method as for the wet coating layer 13a. Specifically, an SiC substrate whose area is 200% or more larger than that of the second member 12 and with a smooth surface (surface roughness of 0.03 $\mu$m or less, measured according to JIS B 0601:1994) that serves as a reference surface is provided. The second member 12 is placed on the reference surface of the SiC substrate. The thickness of the second member 12 is then calculated using a non-contact surface profiler.

Subsequently, a plate-shaped weight 20 smaller in area than the second member 12 is placed on the second member 12 using a chip mounter with an applied pressure of 0.8 MPa, as illustrated in Fig. 3(b). The time interval between the contact of the weight 20 with the second member 12 and the pressure reaching 0.8 MPa is set to within five seconds, and the time for maintaining the pressure of 0.8 MPa is set to two seconds.

The weight 20 is then removed using a suction pickup, forming a stack 14 as illustrated in Fig. 3(c). The average distance D (Fig. 2) from the upper surface 11b of the first member 11 to the upper surface 12c of the second member 12 in the stack 14 is measured. The average distance D can be calculated by the same calculation method for the average thickness of the wet coating layer 13a. Specifically, the average distance D (Fig. 2) from the upper surface 12c of the second member 12 to the upper surface 11b of the first member 11 is calculated by the same calculation method as for the average thickness of the wet coating layer 13a, except that Rectangle T is positioned 500 $\mu$m inside from each of the vertical and horizontal edges of the second member 12 to be scanned. The difference obtained by subtracting the average thickness B of the second member 12 from the average distance D is defined as the average distance Y from the upper surface 11b of the first member to the lower surface 12b of the second member.

While the value P (press-in ratio) should be in the aforementioned range, the value Y (average distance) in equation (1) defining the press-in ratio P is preferably in the range of from 5 to 500 $\mu$m and more preferably from 10 to 300 $\mu$m, to ensure the reliable fixation of the second member 12 by the dried coating layer 13b and sufficiently increase the joint strength between the first member 11 and the second member 12.

The pressure for pressing the second member 12 into the dried coating layer 13b is preferably 0.004 to 5 MPa, more preferably 0.01 to 4.5 MPa, and even more preferably 0.05 to 4 MPa, to ensure proper fixation of the second member 12 by the dried coating layer 13b and sufficiently enhance the joint strength between the first member 11 and the second member 12.

After the desired pressure is reached, it is maintained for at least 0.01 second, and preferably at least 0.05 seconds, to ensure proper fixation of the second member 12 by the dried coating layer 13b and sufficiently enhance the joint strength between the first member 11 and the second member 12 during the subsequent heating step. The time of maintaining the reached pressure is not particularly limited unless there is a significant decline in productivity. For instance, it can be seven seconds or shorter.

Once the second member 12 is fixed as illustrated in Fig. 2, it is less likely to shift relative to the first member 11 even with an outer force imposed on the stack 14. As a result, the positional relationship between the first member 11 and the second member 12 is stably and reliably retained during subsequent processing of the stack 14, for example, while the stack is transferred to a sintering furnace for the heating step hereinafter described.

The stack 14, in which the second member 12 is fixed by the dried coating layer 13b, is then subjected to a heating step. Because the heating step is carried out at a different site from the step of obtaining the stack described above, the stack 14 is transferred to equipment for heating the stack 14. An external force, such as vibration, may sometimes be applied to the stack 14 during transfer. However, since the proper fixation of the second member 12 by the dried coating layer 13b, accomplished by the step of obtaining the stack, prevents the positional shift of the second member 12. The heating equipment may incorporate a mounting unit for the second member 12. In such cases, the stack 14 can be heated *in situ*.

The heating step, in which heat is applied to the stack 14, is carried out either after pressure is applied to the stack 14 or while the stack 14 is pressed, or with no pressure applied. To ensure reliable sintering of the copper particles in the dried coating layer 13b and reliably enhance the joint strength between the first and second members 11 and 12, the heating temperature is preferably 180°C to 350°, and more preferably 200°C to 300°C.

In the case when the stack 14 is heated after or during pressure application, the pressure applied is preferably 0.1 to 35 MPa, more preferably 1 to 30 MPa, and even more preferably 2 to 28 MPa, to properly fix the second member 12 by the dried coating layer 13b. The heating can be executed in various atmospheres, including air, inert gas, and reducing atmospheres.

By adopting the above-described fixing method, a desired joint structure (not shown) is produced. In the resulting joint structure, the first and second members are joined via a joint layer formed of a sintered body of copper particles.

The paste used in the method for joining by the aforementioned fixing method and the first and second members will then be described.

The paste for use in the invention contains copper particles and an organic solvent and may contain various optional modifiers.

The copper particles used in the paste may have any shapes, including spherical and non-spherical shapes. As used herein, the term "spherical shape" denotes a shape with a circularity coefficient of 0.85 or greater. The circularity coefficient is calculated from expression: $(4\pi S)/L^2$, wherein S is the area of the two-dimensional projected image of a primary particle; and L is the perimeter of the primary particle in a scanning electron microscopic (SEM) image of copper particles. The term "non-spherical shape" refers to a shape with a circularity coefficient of smaller than 0.85.

The non-spherical shapes include polyhedra, such as flaky, hexahedral, and octahedral shapes, spindle shapes, and irregular shapes. The term "flaky shape" used herein refers to a shape with a pair of opposing main faces and lateral faces perpendicular to the main faces. Each of the main and the lateral faces can each have a flat, curved, or uneven surface.

The copper particles may have two or more different shapes. It is particularly preferred that the copper particles include flaky particles and spherical particles to provide a joint structure with high joint strength. The copper particles may have different sizes or different shapes and sizes.

The particle size of spherical copper particles is measured as follows. An SEM image is taken of the copper particles at a magnification of 10,000 to 150,000. At least 50 primary copper particles with clear contours are selected, and their Heywood diameters are measured. Assuming the particles are true spheres, the volumes of the particles are calculated from the Heywood diameters. The cumulative volume diameter at 50% of the cumulative volume is taken as the particle size of the copper particles.

The particle size of the copper particle is preferably greater than 0.1 $\mu$m, more preferably 0.11 $\mu$m or greater, and even more preferably 0.12 $\mu$m or greater, and preferably 0.55 $\mu$m or smaller, and more preferably 0.5 $\mu$m or smaller. With copper particle sizes exceeding 0.1 $\mu$m, cracking due to shrinkage is less likely to occur during the heating step for firing the dried coating layer 13b to a sintered body (joint layer). When the copper particle sizes are not greater than 0.55 $\mu$m, the copper particles in the dried coating layer 13b are sintered sufficiently.

In the case of flaky copper particles, the flaky copper particles are observed by SEM at a magnification of 500 to 50,0000, and images of copper particles with clearly defined contours are obtained and subjected to image analysis. Specifically, each particle is rotated 360° in a direction parallel to the plate surface (main face) of the flaky shape, and for every two-dimensional projection image, a virtual circumscribed rectangle is considered. Among these rectangles, the one having the largest side length is selected, and its long side is defined as the major axis of that particle. Fifty or more particles are randomly selected, the major axes of the respective particles are measured, and the arithmetic mean of these values is determined as the particle size. The image analysis is performed using, for example, Mac-View, a particle size distribution analysis software developed by Mountech Co., Ltd.

The flaky copper particles preferably have a particle size of 0.3 to 50 $\mu$m, more preferably 0.5 to 40 $\mu$m, and even more preferably 1 to 20 $\mu$m. When combined with spherical copper particles, the flaky copper particles with their size being in the above range ensure excellent sinterability of the dried coating layer 13b while preventing the sintered body from cracking due to excessive volume shrinkage of the dried coating layer 13b.

To increase packing properties of the copper particles, thereby ensuring sufficient joint strength, the content of the copper particles in the paste is preferably 50 to 95 mass%, more preferably 60 to 95 mass%.

The copper particles may have a surface treating agent adhering thereto. The surface treating agent adhering to the surface of the copper particles is effective in inhibiting excessive agglomeration of the copper particles.

The organic solvent used to prepare the paste preferably has a boiling point M of 150°C to 300°C, more preferably 160°C to 290°C, and even more preferably 170°C to 280°C. Examples of such solvents include monohydric alcohols, polyhydric alcohols, polyhydric alcohol alkyl ethers, polyhydric alcohol aryl ethers, esters, nitrogen-containing heterocyclic compounds, amides, amines, and saturated hydrocarbons. These organic solvents can be used either individually or in combination of two or more thereof. Using an organic solvent having a boiling point within the above range in the paste facilitates the control of solvent vaporization from the wet coating layer 13a and allows the dried coating layer 13b to achieve an appropriate hardness.

In using a plurality of organic solvents in the paste, it is desirable for at least one of them to have a boiling point within the above range. It is more desirable for all the organic solvents to have a boiling point within the above range.

In order to control the solvent vaporization from the wet coating layer 13a thereby to result in an appropriate hardness of the dried coating layer 13b, the organic solvent content in the paste is preferably 3.0 to 30.0 mass%, more preferably 5.0 to 29.0 mass%, and even more preferably 7.0 to 28.0 mass%.

The paste may contain modifiers for modifying various characteristics. The modifiers include reducing agents, viscosity modifiers, and surface tension modifiers.

Recommended reducing agents are those capable of promoting sintering of the copper particles, including monohydric alcohols, polyhydric alcohols, amino alcohols, citric acid, oxalic acid, formic acid, ascorbic acid, aldehyde, hydrazine and its derivatives, hydroxylamine and its derivatives, dithiothreitol, phosphites, hydrogen phosphites, and phosphorous acid and its derivatives.

Recommended viscosity modifiers are those capable of adjusting the viscosity of the paste preferably within the range described below, including ketones, esters, alcohols, glycols, hydrocarbons, and polymers.

Suitable surface tension modifiers are those capable of adjusting the surface tension of the wet coating layer 13a, including polymers, such as acrylic surfactants, silicone surfactants, alkyl polyoxyethylene ethers, and fatty acid glycerol esters; and monomers, such as alcohols, hydrocarbons, esters, and glycols.

To enhance the coating properties or printing properties of the paste, the paste preferably has a viscosity of 10 to 200 Pa·s and more preferably 15 to 200 Pa·s or less at a shear rate of 10 s$^{-1}$. The viscosity of the paste can be measured using a rheometer MARS III from Thermo Scientific under the following conditions:

- Measurement mode: shear-rate dependence measurement
- Sensor: parallel type (Φ 20 mm)
- Measuring temperature: 25°C
- Gap: 0.300 mm
- Shear rate: 0.05 - 120.01 s$^{-1}$
- Measuring time: 2 mins

The first member 11 and the second member 12 are not limited in material. Typically, both the first and second members 11 and 12 preferably contain a metal on their sides to be joined. For example, at least one of the first and second members 11 and 12 can be a member having its surface formed of a metal. In this context, the term "metal" refers to an elemental metal, which is not in the form of a compound with another element or an alloy composed of two or more metals. Examples of the "metal" include copper, silver, gold, aluminum, palladium, nickel, and alloys composed of two or more of these metallic elements.

When at least one of the first and second members 11 and 12 has a metal surface, that surface is typically preferably flat but may sometimes be curved.

Examples of each of the first and second members 11 and 12 include spacers, heatsinks, and semiconductor devices, each made of the above-recited metals; and substrates having at least one of the above-recited metals on the surface thereof, such as insulating substrate formed of a ceramic or aluminum nitride plate having a metal layer (e.g., copper) on the surface thereof. When a semiconductor device is used as the first member 11 and/or the second member 12, the semiconductor device contains at least one of Si, Ga, Ge, C, N, As, and so on.

The first member 11 is preferably a substrate, while the second member 12 is preferably any of a spacer, heatsink, and semiconductor device.

At least one of the first and second members 11 and 12 can be a dried body of a paste containing fine metal particles and an organic solvent. Specifically, the first member 11 may be a member with a metal surface, and the second member 12 may be a dried body of a paste containing fine metal particles and an organic solvent. The dried body of a paste is preferably prepared by applying the paste on a supporting substrate made of a metal (e.g., copper), followed by drying.

The joint structure obtained by the method of the invention is suited for use in devices handling high currents, such as automotive electronic circuits and electronic circuits incorporating power devices.

The following clauses are illustrative of various aspects of the invention, including the method for producing a joint structure, the method for producing a stack, and the method for joining.

1. A method for producing a joint structure having a first member, a second member and a joint layer joining the first member and the second member,

the method comprising

a step of applying a paste comprising copper particles and an organic solvent to the first member to form a coating layer,
a drying step of drying the coating layer to partially remove the organic solvent contained in the coating layer,
a pressing step of pressing the second member into the coating layer until a portion of the second member is embedded in the coating layer to form a stack comprising the first member, the coating layer, and the second member in that order, and
a heating step of heating the stack, and

the pressing step being performed to achieve a press-in ratio P of from 1.0 to 50, the press-in ratio P being defined as 100 - (Y/X × 100),
wherein X represents an average thickness (μm) of the coating layer in a state after the drying step and before pressing the second member into the coating layer; and

Y represents an average distance (µm) from an upper surface of the first member to a lower surface of the second member in a state after forming the stack.

2. The method as set forth in clause 1, wherein the average thickness X of the coating layer after the drying step is 15 µm or more.

3. The method as set forth in clause 1 or 2, wherein the paste contains 3.0 to 30.0 mass% of the organic solvent, and in the drying step, the coating layer is dried in such a manner that the mass of the coating layer is reduced by 3.0 to 30.0 mass%.

4. The method as set forth in any one of clauses 1 to 3, wherein the organic solvent has a boiling point M of 150°C to 300°C, and

the drying step is performed at a heating temperature of 20°C to M°C.

5. The method as set forth in any one of clauses 1 to 4, wherein the pressing for forming the stack is performed by applying a pressure of 0.004 to 5 MPa to the second member to embed the second member into the coating layer.

6. A method for producing a stack for joining a first member and a second member,

the method comprising

a step of applying a paste comprising copper particles and an organic solvent to the first member to form a coating layer,

a drying step of drying the coating layer to partially remove the organic solvent contained in the coating layer, and

a pressing step of pressing the second member into the coating layer until a portion of the second member is embedded in the coating layer to form a stack comprising the first member, the coating layer, and the second member in that order, and

the pressing step being performed to achieve a press-in ratio P of 1.0 to 50, the press-in ratio P being defined as 100 - (Y/X × 100),

wherein X represents an average thickness (µm) of the coating layer in a state after the drying step and before pressing the second member into the coating layer; and

Y represents an average distance (µm) from an upper surface of the first member to a lower surface of the second member in a state after forming the stack.

7. A method for joining a first member and a second member,

the method comprising

a step of applying a paste comprising copper particles and an organic solvent to the first member to form a coating layer,

a drying step of drying the coating layer to partially remove the organic solvent contained in the coating layer,

a pressing step of pressing the second member into the coating layer until a portion of the second member is embedded in the coating layer to form a stack comprising the first member, the coating layer, and the second member in that order, and

a heating step of heating the stack, and

the pressing step being performed to achieve a press-in ratio P of from 1.0 to 50, the press-in ratio P being defined as 100 - (Y/X × 100),

wherein X represents an average thickness (µm) of the coating layer in a state after the drying step and before pressing the second member into the coating layer; and

Y represents the average distance (µm) from an upper surface of the first member to a lower surface of the second member in a state after forming the stack.

## Examples

The invention will now be illustrated in greater detail with reference to Examples, but it should be understood that the scope of the invention is not deemed to be limited thereto. Unless otherwise specified, all the percentages are given by mass.

## Examples 1 and 2 and Comparative Examples 1 and 2

(1) Preparation of paste

The components used to make a paste were:

- Copper powder 1:      spherical copper particles (particle size: 0.1-0.2 $\mu$m) 53%
- Copper powder 2:      flaky copper particles (particle size: 4.5 $\mu$m) 23%
- Organic solvent 1:      hexylene glycol (b. pt.: 198°C) 18.9%
- Organic solvent 2:      diethylene glycol (b. pt.: 244.3°C) 2.4%
- Organic solvent 3:      polyethylene glycol 300 (b. pt.: 250°C) 0.76%
- Reducing agent:      bis(2-hydroxyethyl)iminotris(hydroxymethyl)methane 1.9%

(2) Paste application to first member

A 20 mm by 20 mm by 2 mm copper substrate was used as a first member. The paste was printed on the substrate using a metal mask (6 mm $\times$ 6 mm; thickness: 100 $\mu$m) to form a rectangular wet coating layer. The wet coating layer was dried in the atmosphere at 40°C for the period shown in Table 1 below to remove the organic solvent. Table 1 also shows the mass loss ratio of the coating layer due to the solvent removal and the thickness of the resulting dried coating layer.

The mass loss ratio of the wet coating layer was determined as follows. The mass of the copper substrate was measured using an electronic balance. Then, the copper substrate with the wet coating layer was measured using the electronic balance. The mass of the substrate before printing was subtracted from the mass of the copper substrate with the wet coating layer to yield the mass of the printed wet coating layer. After drying the substrate with the wet coating layer for a prescribed period of time, the mass of the substrate with the dried coating layer was measured using the electron balance. The mass of the substrate with the dried coating layer was subtracted from the mass of the copper substrate with no coating layer to give the mass of the coating layer that had reduced as a result of drying. This value was divided by the initial wet coating layer mass and multiplied by 100 to obtain a mass loss ratio (%) of the wet coating layer.

(3) Placement of second member on dried coating layer

Assuming a model semiconductor power device, a 5 mm by 5 mm Ag-plated SiC chip was provided as a second member to be joined. Using a chip mounter, the SiC chip was placed in the central portion of the dried coating layer with its Ag-plated side in contact with the dried coating layer with an applied pressure of 0.004 MPa. The average thickness B of the second substrate is shown in Table 1.

(4) Stack formation

A pressure shown in Table 1 was applied to the side opposite the Ag-plated side of the SiC chip for two seconds, thereby pressing the SiC chip into the dried coating layer, forming a stack. The press-in ratio P achieved by the pressure application was calculated according to the aforementioned method. The results are shown in Table 1.

In Comparative Example 1, the mass loss ratio of the wet coating layer was as low as 3.1%. Thus, the dried coating layer easily deformed, so that a portion of the dried coating layer bulged beyond the upper surface of the second member when the pressure was applied. The thickness of each layer was measured in this state to calculate the press-in ratio P.

(5) Firing of stack

The stack was transferred to a sintering furnace. After applying a pressure of 9 MPa to the stack in a nitrogen atmosphere, the temperature was raised to 280°C. This temperature was maintained for 5 minutes, whereby the coating layer was fired into a joint layer and completed a joint structure.

Evaluation 1

The stack obtained in step (4) was inverted over a period of one second to visually observe any positional shift or detachment of the SiC chip. The results are shown in Table 1.

Evaluation 2

To confirm the joint strength of the joint structure obtained in step (5), the shear strength was determined under the following conditions. The shear strength (MPa) is defined as breaking load (N)/bottom area (mm$^2$) of the SiC chip. The results are shown in Table 1. In Comparative Example 2, the evaluation was not made because the SiC chip detached during the evaluation for positional shift or detachment of SiC chip. The result is denoted as "-" in Table 1.

- Measuring equipment: Condor Sigma, from XYZTEC
- Load cell: 200 kgf
- Shear tool: width, 6.0 mm; thickness, 2.0 mm; 1/4" shaft (model No.: TOS663060)
- Shear rate: 50 μm/s
- Shear height: 0.02 mm (Zero point is the top of the printed 6-mm-side square coating layer)

**Table 1**

|  | Compara. Example 1 | Example 1 | Example 2 | Compara. Example 2 |
|---|---|---|---|---|
| Drying Time for Wet Coating Layer 13a (min) | 10 | 40 | 60 | 120 |
| Mass Loss Ratio of Wet Coating Layer 13a (%) | 3.1 | 12.6 | 15.6 | 18.2 |
| Avg. Thickness B of 2nd Member 12 (μm) | 205.0 | 204.2 | 205.6 | 205.2 |
| Avg. Thickness X of Dried Coating Layer 13b (μm) | 99 | 74 | 74 | 81 |
| Avg. Thickness A after Placing 2nd Member 12 at 0.004 MPa (μm) | 304.7 | 278.4 | 280.0 | 286.3 |
| Load for Pressing 2nd Member 12 (MPa) | 0.8 | 0.8 | 0.8 | 0.8 |
| Avg. Distance D (μm) | 225.9 | 267.0 | 273.5 | 286.0 |
| Avg. Distance Y (μm) | 20.9 | 62.8 | 67.9 | 80.0 |
| Press-in ratio P = 100 - (Y/X*100) | 78.9 | 15.1 | 8.2 | 0.2 |
| Positional Shift or Detachment of 2nd Member 12 | no | no | no | yes |
| Shear Strength (MPa) | 0 | 53 | 53 | - |

As can be seen clearly from the results in Table 1, the method adopted in Examples prevents the SiC chip from shifting or detaching and ensures sufficient joint strength.

**Industrial Applicability**

The invention provides a method for producing a joint structure in which members are joined via a joint material without involving positional shifting or detachment.

**Claims**

1. A method for producing a joint structure having a first member, a second member and a joint layer joining the first member and the second member,

    the method comprising

        a step of applying a paste comprising copper particles and an organic solvent to the first member to form a coating layer,

a drying step of drying the coating layer to partially remove the organic solvent contained in the coating layer,
a pressing step of pressing the second member into the coating layer until a portion of the second member is embedded in the coating layer to form a stack comprising the first member, the coating layer, and the second member in that order, and
a heating step of heating the stack, and

the pressing step being performed to achieve a press-in ratio P of from 1.0 to 50, the press-in ratio P being defined as 100 - (Y/X × 100),
wherein X represents an average thickness ($\mu$m) of the coating layer in a state after the drying step and before pressing the second member into the coating layer; and
Y represents an average distance ($\mu$m) from an upper surface of the first member to a lower surface of the second member in a state after forming the stack.

2. The method according to claim 1, wherein the average thickness X of the coating layer after the drying step is 15 $\mu$m or more.

3. The method according to claim 1 or 2, wherein the paste contains 3.0 to 30.0 mass% of the organic solvent, and in the drying step, the coating layer is dried in such a manner that the mass of the coating layer is reduced by 3.0 to 30.0 mass%.

4. The method according to claim 1 or 2, wherein the organic solvent has a boiling point M of 150°C to 300°C, and the drying step is performed at a heating temperature of 20°C to M°C.

5. The method according to claim 1 or 2, wherein the pressing for forming the stack is performed by applying a pressure of 0.004 to 5 MPa to the second member to embed the second member into the coating layer.

6. A method for producing a stack for joining a first member and a second member,

the method comprising

a step of applying a paste comprising copper particles and an organic solvent to the first member to form a coating layer,
a drying step of drying the coating layer to partially remove the organic solvent contained in the coating layer, and
a pressing step of pressing the second member into the coating layer until a portion of the second member is embedded in the coating layer to form a stack comprising the first member, the coating layer, and the second member in that order, and

the pressing step being performed to achieve a press-in ratio P of 1.0 to 50, the press-in ratio P being defined as 100 - (Y/X × 100),
wherein X represents an average thickness ($\mu$m) of the coating layer in a state after the drying step and before pressing the second member into the coating layer; and
Y represents an average distance ($\mu$m) from an upper surface of the first member to a lower surface of the second member in a state after forming the stack.

7. A method for joining a first member and a second member,

the method comprising

a step of applying a paste comprising copper particles and an organic solvent to the first member to form a coating layer,
a drying step of drying the coating layer to partially remove the organic solvent contained in the coating layer,
a pressing step of pressing the second member into the coating layer until a portion of the second member is embedded in the coating layer to form a stack comprising the first member, the coating layer, and the second member in that order, and
a heating step of heating the stack, and

the pressing step being performed to achieve a press-in ratio P of from 1.0 to 50, the press-in ratio P being defined as 100 - (Y/X $\times$ 100),

wherein X represents an average thickness ($\mu$m) of the coating layer in a state after the drying step and before pressing the second member into the coating layer; and

Y represents the average distance ($\mu$m) from an upper surface of the first member to a lower surface of the second member in a state after forming the stack.

EP 4 723 164 A1

Fig. 1

(a)   (b)   (c)   (d)

Fig. 2

Fig. 3

(a)          (b)          (c)

## INTERNATIONAL SEARCH REPORT

| International application No. |
| --- |
| **PCT/JP2024/020076** |

**A. CLASSIFICATION OF SUBJECT MATTER**

*H01L 21/52*(2006.01)i; *B22F 1/00*(2022.01)i; *B22F 7/04*(2006.01)i; *B22F 9/00*(2006.01)i; *H05K 1/14*(2006.01)i; *H05K 3/32*(2006.01)i; *H05K 3/36*(2006.01)i

FI: H01L21/52 D; B22F1/00 L; B22F7/04 D; B22F9/00 B; H05K3/32 A; H05K1/14 J; H05K3/36 A

According to International Patent Classification (IPC) or to both national classification and IPC

**B. FIELDS SEARCHED**

Minimum documentation searched (classification system followed by classification symbols)

H01L21/52; B22F1/00; B22F7/04; B22F9/00; H05K1/14; H05K3/32; H05K3/36

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2021-98875 A (TOYO INK SC HOLDINGS CO., LTD.) 01 July 2021 (2021-07-01) entire text, all drawings | 1-7 |
| A | JP 2014-110282 A (TOYOTA JIDOSHA KABUSHIKI KAISHA) 12 June 2014 (2014-06-12) entire text, all drawings | 1-7 |
| A | JP 2019-216183 A (MITSUBISHI ELECTRIC CORPORATION) 19 December 2019 (2019-12-19) entire text, all drawings | 1-7 |
| A | JP 2021-2557 A (TOHOKU UNIVERSITY) 07 January 2021 (2021-01-07) entire text, all drawings | 1-7 |

☐ Further documents are listed in the continuation of Box C.   ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
| --- | --- |
| **29 July 2024** | **06 August 2024** |

| Name and mailing address of the ISA/JP | Authorized officer |
| --- | --- |
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**
Information on patent family members

International application No.

**PCT/JP2024/020076**

| Patent document cited in search report | | | Publication date (day/month/year) | Patent family member(s) | Publication date (day/month/year) |
|---|---|---|---|---|---|
| JP | 2021-98875 | A | 01 July 2021 | (Family: none) | |
| JP | 2014-110282 | A | 12 June 2014 | (Family: none) | |
| JP | 2019-216183 | A | 19 December 2019 | (Family: none) | |
| JP | 2021-2557 | A | 07 January 2021 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2016127219 A